Europäisches Patentamt

European Patent Office

Office européen des brevets

(11) Numéro de publication: **0 391 751**

**A2**

## (12) DEMANDE DE BREVET EUROPEEN

(21) Numéro de dépôt: **90400219.3**

(51) Int. Cl.5: **G01R 1/20**

(22) Date de dépôt: **25.01.90**

(30) Priorité: **03.02.89 FR 8901389**

(43) Date de publication de la demande:
**10.10.90 Bulletin 90/41**

(84) Etats contractants désignés:
**DE GB IT**

(71) Demandeur: **VALEO ELECTRONIQUE**
**12-14, Rue Jean Bart**
**F-78390 Voisins-Le-Bretonneux(FR)**

(72) Inventeur: **Vidal, Francis**
**22, rue Georges Clémenceau**
**F-92170 Vanves(FR)**
Inventeur: **Tardif, François**
**83, Avenue du Maine**
**F-75014 Paris(FR)**
Inventeur: **Ap, Ngy Srun**
**40, rue de la Remise à Grouan**
**F-93420 Villepinte(FR)**

(74) Mandataire: **Gamonal, Didier et al**
**Société VALEO Service Propriété**
**Industrielle 30, rue Blanqui**
**F-93406 Saint-Ouen Cédex(FR)**

(54) **Resistance shunt.**

(57) La résistance shunt, constituée d'une plaque de résine epoxy (1) recouverte sur l'une de ses faces d'une de ses faces d'une fine couche de constantan (3), caractérisé en ce qu'il comprend une résistance (R) comprise entre deux conducteurs (4), (5) brasés sur la face recouverte de constantan dont les extrémités (6), (7) dépassant ladite plaque constituent les moyens de connexion dudit shunt et en ce qu'au moins une aile (8,8') est ménagée de matière à l'extérieur de ladite résistance (R).

Fig. 1

## RESISTANCE SHUNT

La présente invention concerne d'une manière générale les résistances électriques utilisées en tant que shunts.

De tels shunts s'incorporent, de manière connue en soi, à des ensembles électriques ou électroniques et sont conçus de façon à ce qu'ils puissent être parcourus par un courant élevé tout en ayant une valeur de résistance ohmique relativement faible.

Autrement dit, ils sont constitués de telle sorte qu'ils peuvent assurer un fonctionnement correct tout en subissant une forte élévation de température et, de ce fait, de tels shunts ont, en règle générale des dimensions relativement importantes.

Le problème de leur réalisation devient plus compliqué à résoudre quand leur valeur ohmique est très faible et qu'ils sont parcourus par un courant de forte intensité.

En effet, quand on sait que la valeur d'une résistance est régie par la formule $R = \sigma l/s$ dans laquelle l est la longueur et s la section, on conçoit que pour des valeurs de résistance très faibles on doit avoir une longueur minimum pour avoir une section suffisante de manière à pouvoir effectuer les raccordements électriques nécessaires.

Se posent alors des problèmes particulièrement difficiles à résoudre pour assurer une dissipation thermique satisfaisante, ceci d'autant plus lorsque ledit shunt contribue au fonctionnement d'un ensemble électronique destiné à être installé sur un véhicule automobile et que ses dimensions doivent être les plus réduites possibles de manière à pouvoir s'intégrer facilement dans cet ensemble.

Du fait de l'environnement dans lequel il doit fonctionner, ledit shunt est soumis à des variations de température ambiante importantes ce qui complique sa réalisation d'autant plus que, dans l'utilisation à laquelle il est destiné, il doit garder une valeur ohmique quasi constante et donc, être constitué d'un matériau dont le coefficient de résistivité $\sigma$ doit varier le moins possible avec la température.

Après de nombreux essais on a pu constater que le matériau pouvant le mieux répondre à ce critère était un alliage de cuivre et de nickel plus connu sous le nom de constantan.

On sait réaliser des résistances de très faible valeur avec un tel matériau. Celles-ci sont réalisées avec une plaque de résine epoxy sur l'une des faces de laquelle on a déposé une fine couche (quelques dizaines de microns) de constantan ; des fraisures sont pratiquées dans la plaque et la surface délimitée par ces fraisures détermine la valeur de la résistance, dont les moyens de connexion sont constitués par des oeillets sertis dans la plaque.

Si de tels moyens de connexion conviennent pour des courants faibles il n'en est pas de même pour un shunt parcouru par un fort courant. En effet, dans ces conditions, les oeillets doivent être suffisamment éloignés les uns des autres pour subir sans dommages l'élévation de température importante dont ils sont l'objet, ce qui conduit à un shunt de dimensions trop importantes pour qu'il puisse être incorporé facilement à l'ensemble auquel il est destiné.

L'invention a pour but de résoudre ces problèmes. Le shunt suivant l'invention qui est constitué d'une plaque de résine epoxy recouverte sur l'une de ses faces d'une couche de constantan est plus particulièrement caractérisé en ce qu'il comprend une résistance comprise entre deux conducteurs brasés sur ladite face recouverte de constantan dont les extrémités dépassant ladite plaque constituent les moyens de connexion et en ce qu'au moins une aile est ménagée de matière à l'extérieur de ladite résistance.

Les conducteurs sont suffisamment dimensionnés pour subir sans dommage l'élévation de température dont ils sont l'objet et peuvent être suffisamment rapprochés pour que l'ensemble du shunt soit de dimensions réduites.

L'aile ménagée à l'extérieur de la surface constitue un dissipateur thermique efficace et contribue au bon fonctionnement de l'ensemble.

Selon une forme préférée de l'invention on prévoit deux ailes ménagées de matière de part et d'autre des conducteurs afin d'augmenter le refroidissement de l'ensemble.

Dans le même but, la plaque de résine epoxy peut comporter une couche d'aluminium épaisse de quelques millimètres sur sa face opposée à celle recouverte de constantan.

Il va de soit que si, par exemple, trois conducteurs sont brasés sur ladite plaque, ils définissent entre eux deux surfaces égales ou différentes qui déterminent deux shunts de valeur ohmiques égales ou différentes.

La description qui va suivre en regard des dessins fera mieux comprendre comment l'invention peut être obtenue.

- la figure 1 est une vue en plan du shunt suivant l'invention ;

- la figure 2 est une vue du shunt suivant la coupe A-A de la figure 1 ;

- la figure 3 est une vue en plan du shunt, selon une variante de réalisation.

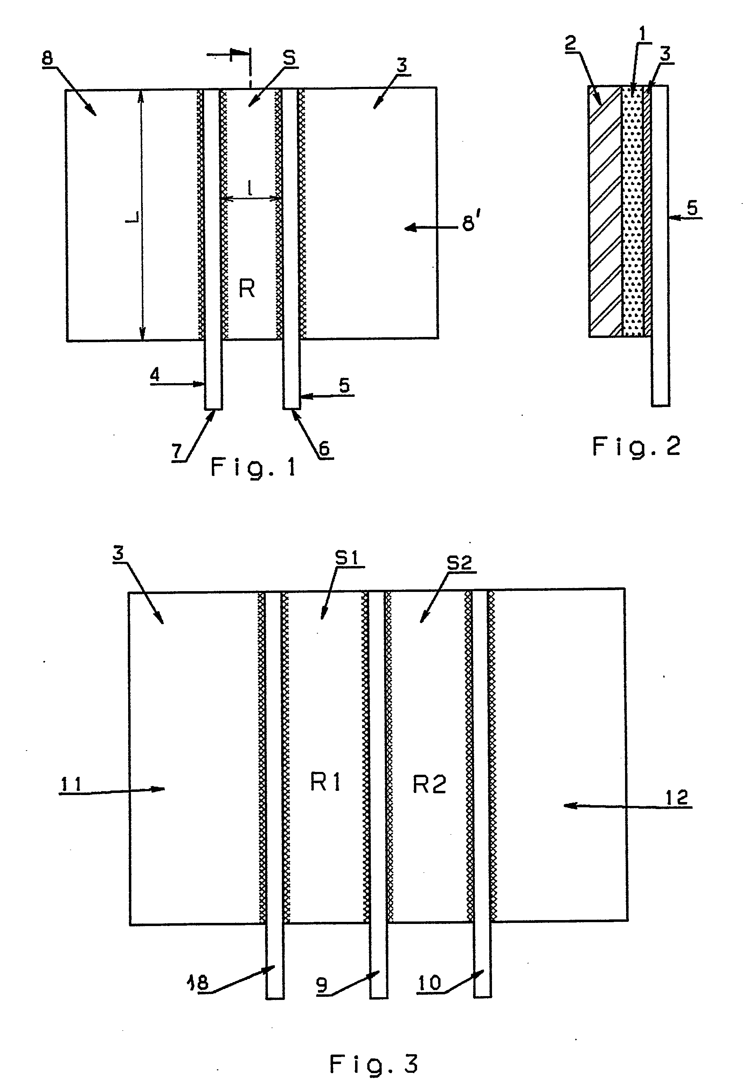

Le shunt représenté aux figures 1 et 2.est constitué d'une plaque 1 de résine epoxy de forme générale rectangulaire recouverte sur l'une de ses faces d'une couche d'aluminium 2 d'une épaisseur de quelques millimètres. Cette couche d'aluminium 2 est destinée à faciliter la dissipation thermique de l'ensemble.

Sur la face opposée est déposée, de manière connue en soi, une couche de constantan 3 d'une épaisseur très faible de quelques dizaines de microns.

Sur cette couche sont brasés 2 fils de cuivre 4,5 dont la section est suffisante pour qu'ils puissent être parcourus par une intensité élevée, de l'ordre de 15 Ampères ou plus.

Ces fils de cuivre 4,5 ou conducteurs ont l'une de leurs extrémités 6,7 qui est à l'extérieur de la couche 3.

Suivant l'invention, ces conducteurs 4 et 5, délimitent entre eux sur la couche 3 une surface S qui détermine la valeur ohmique R du shunt.

Dans l'application choisie, la valeur du shunt sera de l'ordre de 5 milliohms donc très faible par rapport à l'intensité de 15 Ampères qui le traverse.

Pour obtenir cette valeur ohmique, le rapport entre la largeur l et la longueur L de la surface S doit être égal à 4.

Afin que l'ensemble du shunt ait des dimensions suffisamment réduites pour être facilement incorporé au module électronique auquel il est destiné, il est nécessaire que la longueur L soit la plus petite possible d'où une largeur l très faible. Dans l'exemple considéré, la longueur L, qui ne doit pas dépasser 20mm pour des raisons d'encombrements impose une largeur l de 5 mm, ce qui rend impossible toute connection du shunt par des moyens classiques tels qu'oeillets sertis sur la plaque.

Suivant l'invention les connexions électriques du shunt sont réalisées par les extrémités 6,7 des conducteurs.

Du fait, d'une part de l'échauffement important dont il est l'objet, d'autre part l'environnement sévère dans lequel il se trouve, il est nécessaire d'assurer une dissipation thermique importante.

Suivant l'invention celle-ci est assurée par au moins une aile 8,8' ménagée de matière à l'extérieur de la surface S.

Ainsi la chaleur est suffisamment dissipée pour permettre une tenue mécanique satisfaisante de la brasure des conducteurs 4,5 malgré les élévations de température importantes dont elle est l'objet.

On se réfère maintenant à la figure 3 sur laquelle on a représenté deux shunts dont les valeurs ohmiques R1, R2 sont fonction des valeurs des surfaces S1, S2 déterminées sur la surface 3 par trois conducteurs 18,9,10.

De la même manière des ailes 11,12 sont ménagés de matière sur l'extérieur des shunts R1, R2 pour faciliter la dissipation thermique.

Ainsi, sur une même couche de constantan on peut déterminer n valeurs de shunts, ces valeurs étant égales ou différentes, avec n + 1 conducteurs.

## Revendications

1) Shunt, constitué d'une plaque de résine epoxy (1) recouverte sur l'une de ses faces d'une fine couche de constantan (3), caractérisé en ce qu'il comprend une résistance (R) comprise entre deux conducteurs (4),(5) brasés sur la face recouverte de constantan dont les extrémités (6),(7) dépassant ladite plaque constituent les moyens de connexion dudit shunt et en ce qu'au moins une aile (8) est ménagée de matière à l'extérieur de ladite résistance (R).

2) Shunt, selon la revendication 1, caractérisé en ce que deux ailes (8,8') sont ménagées de part et d'autre desdits conducteurs (4,5).

3) Shunt, selon la revendication 1 ou 2, caractérisé en ce qu'il comprend sur une même plaque (1) une pluralité de résistances R1,R2.

4) Shunt, selon l'une des revendications précédentes, caractérisé en ce qu'il comprend une couche d'aluminium épaisse (2).

Fig. 1

Fig. 2

Fig. 3